# EUROPEAN PATENT APPLICATION

(11) **EP 2 910 941 A1**
(43) Date of publication of application: **26.08.2015**
(21) Application number: 13847619.7
(22) Date of filing: 17.10.2013
(51) Int. Cl.: G01N 27/414, H01L 29/786, H01L 51/05

(54) **SENSOR, SENSOR MODULE, AND DETECTION METHOD**

(30) Priority: 18.10.2012 JP 2012230740
(71) Applicant: Bio Sensor Inc., Sapporo-shi, Hokkaido 060-0051 (JP)
(72) Inventor: TAMURA, Kohji, Sapporo-shi, Hokkaido 060-0051 (JP); KOGURE, Tsuneo, Sapporo-shi, Hokkaido 060-0051 (JP); GOTO, Norio, Sapporo-shi, Hokkaido 060-0051 (JP); MUKASA, Koichi, Sapporo-shi, Hokkaido 060-0051 (JP)
(74) Representative: Epping - Hermann - Fischer
(86) International application number: PCT/JP2013/006170
(87) International publication number: WO 2014/061273

(57) **Abstract**

This sensor has: a first capacitance electrode comprising a plate-shaped conductor or semiconductor; a first terminal electrically connected to the first capacitance electrode; a first insulating film disposed at one surface of the first capacitance electrode; a second capacitance electrode comprising a conductor or semiconductor and disposed in a manner so as to oppose a portion of the first capacitance electrode with the first insulating film therebetween; a second terminal electrically connected to the second capacitance electrode; a variable resistance element disposed on the first insulating film; and a reaction section disposed on the other surface of the first capacitance electrode in a direct manner or with a second insulating film therebetween. The variable resistance element includes: a base body disposed on the first insulating film; a third terminal connected to one end of the base body; and a fourth terminal connected to the other end of the base body.

## Description

### Technical Field

The present invention relates to a sensor, a sensor module including the sensor, and a detection method using the sensor or the sensor module.

### Background Art

Various sensors for detecting detection target substances have heretofore been proposed. For example, Patent Literatures (hereinafter "PTLS") 1 and 2 disclose a sensor that includes back gate-type field-effect transistors.

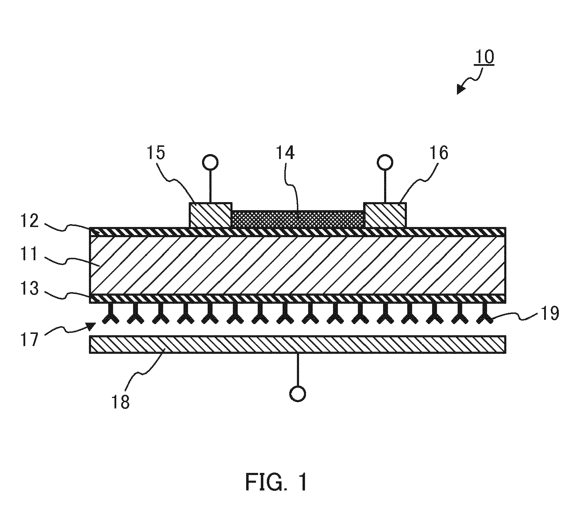

FIG. 1 is a cross-sectional schematic view illustrating the configuration of the sensors disclosed in PTLS 1 and 2. As illustrated in FIG. 1, sensor 10 includes: silicon substrate 11; first insulating film 12 formed on one side of silicon substrate 11; second insulating film 13 formed on the other side of silicon substrate 11; channel 14 disposed on first insulating film 12; source electrode 15 connected to one end of channel 14; drain electrode 16 connected to the other end of channel 14; reaction section 17 disposed on second insulating film 13; and gate electrode 18 disposed so as to face second insulating film 13. In reaction section 17, recognition substance 19 such as antibody is immobilized on second insulating film 13. Gate electrode 18 is detachable; it is detached when an analyte is fed to reaction section 17 and, when measurement is carried out, it is disposed so as to face second insulating film 13. Gate electrode 18 is for example an aluminum plate.

The sensor disclosed in PTL 1 includes channel 14 formed of carbon nanotubes. The sensor disclosed in PTL 2 includes channel 14 formed of a polysilicon film. In sensor 10, silicon substrate 11, first insulating film 12, second insulating film 13, channel 14, source electrode 15, drain electrode 16, and gate electrode 18 function as back gate-type field-effect transistors.

A procedure for detecting a detection target substance using sensor 10 illustrated in FIG. 1 will now be described. First, a voltage to be applied to gate electrode 18 is swept with gate electrode 18 being in contact with reaction section 17 (second insulating film 13), and a current value between source electrode 15 and drain electrode 16 is recorded. Subsequently, an analyte is fed to reaction section 17 with gate electrode 18 being separated from reaction section 17 (second insulating film 13), allowing the detection target substance contained in the analyte to react with recognition molecules 19 immobilized on second insulating film 13. Subsequently, a voltage to be applied to gate electrode 18 is swept with gate electrode 18 being again in contact with reaction section 17 (second insulating film 13), and a current value between source electrode 15 and drain electrode 16 is recorded. Based on the change in current value between before and after analyte feeding as obtained through the above-described procedure, detection of a detection target substance is made possible.

### Citation List

### Patent Literature

PTL 1
   WO2006/103872
PTL 2
   WO2009/144878

### Summary of Invention

### Technical Problem

Sensor 10 of the related art described above has the drawback of being instable in detection precision.

In the case of sensor 10 of the related art, a cycle of detachment of gate electrode 18 from second insulating film 13 and placement of gate electrode 18 on second insulating film 13 need to be carried out multiple times. The state of contact between gate electrode 18 and second insulating film 13 undesirably changes between different cycles. Moreover, when gate electrode 18 formed of aluminum plate or the like is placed on second insulating film 13, defects are easily formed in second insulating film 13. Thus, in sensor 10 of the related art, such problems as injection of charges into the silicon substrate due to variation in the contact state of the gate electrode and/or to the breakage of the insulating film easily occur. As a consequence, sensor 10 tends to exhibit instable detection precision.

An object of the present invention is to provide a sensor and a sensor module which are superior in detection precision and detection stability, and a detection method using the same.

### Solution to Problem

The present invention relates to sensors given below.
[1] A sensor including:
   a first capacitor electrode made of a plate-shaped conductor or semiconductor;
   a first terminal electrically connected to the first capacitor electrode and may be electrically connected to an outside;
   a first insulating film disposed on one side of the first capacitor electrode;
   a second capacitor electrode made of conductor or semiconductor, the second capacitor electrode being disposed to face a part of the first capacitor electrode across the first insulating film;
   a second terminal electrically connected to the second capacitor electrode and may be electrically connected to an outside;
   a variable resistance element including a base body disposed on the first insulating film, a third terminal electrically connected to one end of the base body, and a fourth terminal electrically connected to the other end of the base body; and
   a reaction section disposed on the other side of the first capacitor electrode either directly or with a second insulating film provided between the first capacitor electrode and the reaction section.
[2] The sensor according to [1], wherein the first capacitor electrode is an impurity-doped silicon substrate.
[3] The sensor according to [1] or [2], wherein the base body is a carbon nanotube or a polysilicon film.
[4] The sensor according to [3], wherein the base body is a non-doped polysilicon film.
[5] The sensor according to [3] or [4], wherein the first capacitor electrode is an impurity-doped silicon substrate, the base body is a polysilicon film, and the third terminal and the fourth terminals are impurity-doped polysilicon films.
[6] The sensor according to [5], wherein an impurity doped in the first capacitor electrode and an impurity doped in the third terminal and the fourth terminal have different polarities.
[7] The sensor according to any one of [1] to [6], wherein the second capacitor electrode is an film made of polysilicon, metal or alloy.
[8] The sensor according to [7], wherein the first capacitor electrode is an impurity-doped silicon substrate, the second capacitor electrode is an impurity-doped polysilicon film, and an impurity doped in the first capacitor electrode and an impurity doped in the second capacitor electrode have different polarities.
[9] The sensor according to any one of [1] to [8], wherein in the reaction section, a recognition substance which may react with a detection target substance is immobilized on the other side of the first capacitor electrode or on a surface of the second insulating film.
   The present invention also relates to sensor modules given below.
[10] A sensor module including:
   the sensor according to any one of [1] to [9]; and
   a sensor module substrate for connecting the sensor to an external device,
   wherein the sensor is fixed to the sensor module substrate such that the variable resistance element faces the sensor module substrate.
[11] The sensor module according to [10], wherein the sensor module substrate includes two of the sensors fixed thereto.

The present invention also relates to detection methods given below.
[12] A method of detecting a detection target substance in an analyte using the sensor according to any one of [1] to [9] or the sensor module according to [10], the method including:
   a first step of connecting the first terminal and the second terminal to a power source and applying a voltage between the first capacitor electrode and the second capacitor electrode;
   a second step of electrically disconnecting, after the first step, the first capacitor electrode and the second capacitor electrode from the power source by electrically disconnecting the first terminal and the second terminal from the power source;
   a third step of feeding, after the second step, an analyte to the reaction section; and
   a fourth step of measuring, after the third step, a current value between the third terminal and the fourth terminal.
[13] A method of detecting a detection target substance in an analyte using the sensor module according to [11], the method including:
   a first step of electrically connecting the first terminal and the second terminal of both of the two sensors to a power source and applying a voltage between the first capacitor electrode and the second capacitor electrode simultaneously for both of the two sensors;
   a second step of electrically disconnecting, after the first step, the first capacitor electrode and the second capacitor electrode of both of the two sensors from the power source by electrically disconnecting the first terminal and the second terminal from the power source simultaneously for both of the two sensors;
   a third step of feeding, after the second step, an analyte to the reaction section of one of the two sensors; and
   a fourth step of measuring, after the third step, a difference value between 1) a current value between the third terminal and the fourth terminal for the one of the two sensors, and 2) a current value between the third terminal and the fourth terminal for the other one of the two sensors.
[14] The method according to [12] or [13], further including, before the first step, removing residual charges in the first capacitor electrode and the second capacitor electrode.

### Advantageous Effects of Invention

The present invention eliminates the need to repeatedly cause the electrodes to contact the reaction section and therefore enables highly precise and stable detection of the presence or absence of a detection target substance or measurement of the concentration of the detection target substance.

### Brief Description of Drawings

FIG. 1 is a cross-sectional view illustrating a configuration of a sensor of the related art;
FIG. 2 is a cross-sectional view illustrating an exemplary configuration of a sensor of the present invention;
FIGS. 3A to 3E illustrate a manufacturing process for the sensor illustrated in FIG. 2;
FIGS. 4A and 4B illustrate an exemplary configuration of a sensor module of the present invention;
FIGS. 5A and 5B illustrate another exemplary configuration of a sensor module of the present invention;
FIGS. 6A to 6C are cross-sectional views of a sensor of the present invention for explaining the operation principle thereof;
FIG. 7 is a partially enlarged cross-sectional view of a sensor according to Embodiment 1;
FIG. 8 is a partially enlarged plan view of a part of the sensor in FIG. 7 encircled by a broken line;
FIG. 9 is a partially enlarged cross-sectional view of a sensor according to Embodiment 2;
FIG. 10 is a partially enlarged cross-sectional view of a sensor according to Embodiment 3;
FIG. 11 is a partially enlarged cross-sectional view of a sensor according to Embodiment 4;
FIG. 12 is a plan view of a sensor in which a second capacitor electrode is disposed so as to surround a variable resistance element;
FIGS. 13A and 13B are cross-sectional views illustrating a configuration of a device used in Confirmation Experiments 1 to 3;
FIGS. 14A and 14B illustrate two different circuits used in Confirmation Experiments 1 to 3;
FIG. 15 is a graph of measurement results in Confirmation Experiment 1;
FIG. 16 is a graph of measurement results in Confirmation Experiment 2;
FIGS. 17A and 17B are graphs of measurement results in Confirmation Experiment 3;
FIGS. 18A and 18B are cross-sectional views illustrating a configuration of a device used in Confirmation Experiments 4 to 6;
FIGS. 19A to 19C illustrate three different circuits used in Confirmation Experiments 4 to 6;
FIG. 20 is a graph of measurement results in Confirmation Experiment 4;
FIGS. 21A and 21B are graphs of measurement results in Confirmation Experiment 5; and
FIG. 22 is a graph of measurement results in Confirmation Experiment 6.

### Description of Embodiments

Embodiments of the present invention will now be described in detail with reference to the accompanying drawings.

### [Configuration of Sensor]

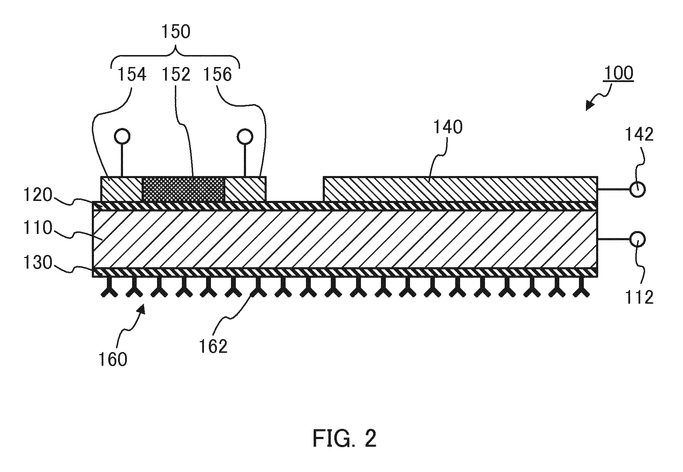

FIG. 2 is a cross-sectional schematic view illustrating an exemplary configuration of a sensor of the present invention. As illustrated in FIG. 2, sensor 100 of present invention includes first capacitor electrode 110, first terminal 112, first insulating film 120, second insulating film 130, second capacitor electrode 140, second terminal 142, variable resistance element 150, and reaction section 160.

First capacitor electrode 110 is a plate-shaped conductor or semiconductor. First capacitor electrode 110 also functions as a substrate of sensor 100. First capacitor electrode 110 is for example an impurity-doped silicon substrate. Other examples of materials for first capacitor electrode 110 include germanium, gallium arsenide (GaAs), indium phosphide (InP), zinc telluride (ZnTe), aluminum, and magnesium. The thickness of first capacitor electrode 110 is not particularly limited and is for example about 0.5 mm.

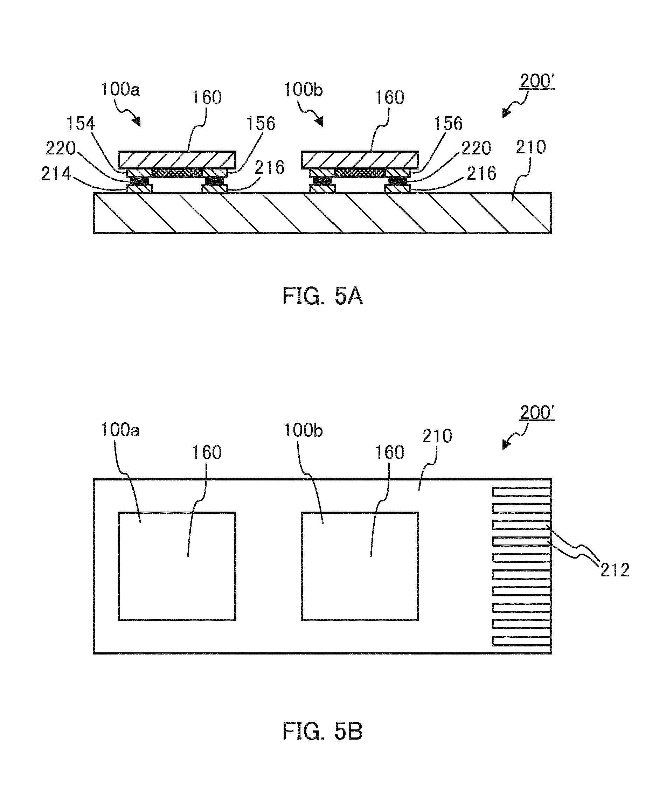

First terminal 112 is electrically connected to first capacitor electrode 110. By providing first terminal 112, it is possible to easily connect first capacitor electrode 110 to an external power source. The position of first terminal 112 is not particularly limited. First terminal 112 is for example disposed on first insulating film 120 (also including the position on the interlayer film formed on first insulating film 120; see FIGS. 5A, 5B, and 7 to 9).

First insulating film 120 is an insulating film disposed on one side of first capacitor electrode 110, and second insulating film 130 is an insulating film disposed on the other side of first capacitor electrode 110. First insulating film 120 insulates between first capacitor electrode 110 and second capacitor electrode 140, and between first capacitor electrode 110 and variable resistance element 150. First insulating film 120 may be disposed on one side of first capacitor electrode 110 either entirely or partially so long as first insulating film 120 can exert the aforementioned function. Moreover, the thickness of first insulating film 120 may be uniform or may be different at different places. Second insulating film 130 insulates between first capacitor electrode 110 and reaction section 160. Second insulating film 130 may be disposed on the other side of first capacitor electrode 110 either entirely or partially so long as second insulating film 130 can exert the aforementioned function. The thickness of second insulating film 130 may be uniform or may be different at different places. The thickness of second insulating film 130 is preferably uniform in an area where reaction section 160 is disposed. Each of first insulating film 120 and second insulating film 130 may be a single layer or may be composed of two or more layers.

First insulating film 120 and second insulating film 130 are for example silicon oxide films. Other examples of materials for first insulating film 120 and second insulating film 130 include silicon nitride, aluminum oxide, titanium oxide, acrylic resins, and polyimides. The thickness of first insulating film 120 and second insulating film 130 is not particularly limited.

Second capacitor electrode 140 is a conductor or semiconductor member disposed on first insulating film 120. Second capacitor electrode 140 faces first capacitor electrode 110 across first insulating film 120. First capacitor electrode 110, first insulating film 120 and second capacitor electrode 140 constitutes a capacitor. Second capacitor electrode 140 is for example a film made of polysilicon, metal or alloy. Examples of metals and alloys for second capacitor electrode 140 include aluminum, aluminum alloy, copper, and copper alloy. It is to be noted that when first capacitor electrode 110 is an impurity-doped silicon substrate and second capacitor electrode 140 is an impurity-doped polysilicon film, the impurity doped in first capacitor electrode 110 and the impurity doped in second capacitor electrode 140 may have the same polarity, but preferably have different polarities.

Variable resistance element 150 is disposed on first insulating film 120 and functions as a transducer. Variable resistance element 150 includes base body 152 formed on first insulating film 120, third terminal 154 electrically connected to one end of base body 152, and forth terminal 156 electrically connected to the other end of base body 152. As will be described later, upon detection of a detection target substance using sensor 100, a current flowing between third terminal 154 and fourth terminal 156 is measured with a voltage being applied between third terminal 154 and fourth terminal 156. Variable resistance element 150 (base body 152) undergoes a change in resistance value by the influence of isolated charges accumulated in first capacitor electrode 110 and charges in first capacitor electrode 110 which have been induced by the charges generated in reaction section 160.

Base body 152 is for example a carbon nanotube or a polysilicon film. When base body 152 is a polysilicon film, base body 152 may be a lightly doped polysilicon film or a non-doped polysilicon film. Third terminal 154 and fourth terminal 156 are for example aluminum films. Further, when base body 152 is a polysilicon film, third terminal 154 and fourth terminal 15 may be impurity-doped polysilicon films. When base body 152 is a lightly doped polysilicon film and third terminal 154 and fourth terminal 156 are impurity-doped polysilicon films, the impurity doped in base body 152 and the impurity doped in third terminal 154 and fourth terminal 156 preferably have the same polarity. It is to be noted that when base body 152 is a polysilicon film, third terminal 154 and fourth terminal 156 are impurity-doped polysilicon films, and first capacitor electrode 110 is an impurity-doped silicon substrate, the impurity doped in first capacitor electrode 110 and the impurity doped in third terminal 154 and fourth terminal 156 may have the same polarity, but preferably have different polarities.

The shape and size of base body 152 are not particularly limited. From the perspective of utilizing the effect of shielding from the outside, base body 152 is preferably surrounded by second capacitor electrode 140. Thus, base body 152 is preferably sized such that it may be surrounded by second capacitor electrode 140.

Reaction section 160 is disposed on second insulating film 130 and is fed with an analyte which may contain a detection target substance. In reaction section 160, recognition substance 162 capable of reacting with a detection target substance is immobilized on second insulating film 130 in advance. The type of recognition substance 162 is not particularly limited so long as it is capable of reacting with a detection target substance. Recognition substance 162 may be organic or inorganic substance. Examples of recognition substance 162 include antibody, antigen, enzyme, lectin, and nucleic acid. When reaction section 160 is fed with an analyte, a detection target substance contained in the analyte reacts with recognition substance 162 immobilized on second insulating film 130.

It is to be noted that although the description of the present embodiment is directed to sensor 100 in which second insulating film 130 is provided between first capacitor electrode 110 and reaction section 160, second insulating film 130 may be dispensed with. Namely, reaction section 160 may be directly disposed on the other side of first capacitor electrode 110. In this case, the recognition substance is immobilized on the other side of first capacitor electrode 110.

### [Method of Manufacturing Sensor]

The method of manufacturing sensor 100 is not particularly limited. Sensor 100 may be manufactured by the common manufacturing process for semiconductor devices.

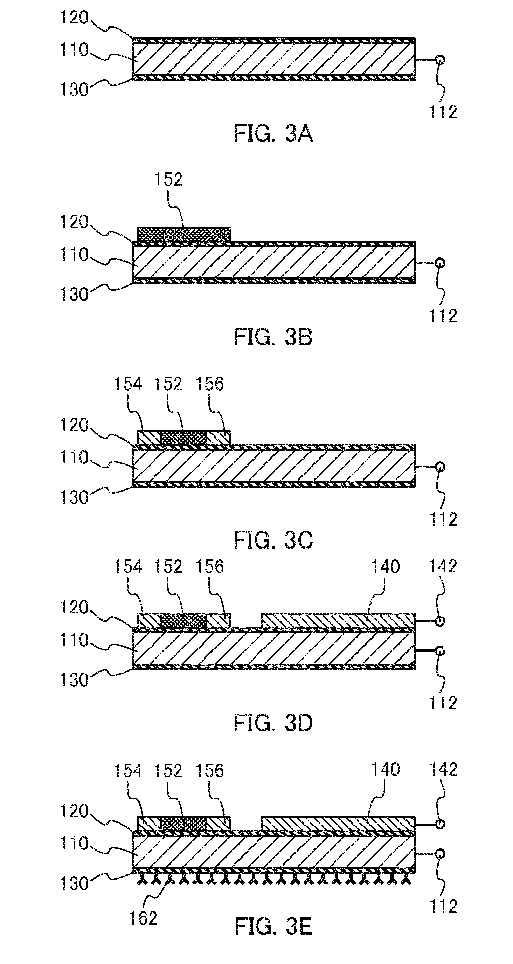

A manufacturing process for sensor 100 will now be described. FIGS. 3A to 3E illustrate an example of a manufacturing process for sensor 100 illustrated in FIG. 2. It is to be noted that the formation process for first terminal 112 and second terminal 142 are not described herein.

First, as illustrated in FIG. 3A, first insulating film 120 and second insulating film 130 are formed on both sides of first capacitor electrode 110, respectively. For example, when first capacitor electrode 110 is an impurity-doped silicon substrate, a silicon oxide film of desired thickness can be formed on the silicon substrate by the thermal oxidation method or the LOCOS method. It is to be noted that when reaction section 160 is directly disposed on the other side of first capacitor electrode 110, second insulating film 130 may not be formed.

Next, as illustrated in FIGS. 3B and 3C, variable resistance element 150 is formed on first insulating film 120 at a predetermined position. In the illustrated example, a rectangular non-doped or lightly doped polysilicon film (base body 152) is formed on first insulating film 120 at a predetermined position (FIG. 3B). Further, the opposing ends of the polysilicon film (base body 152) are doped with impurities to form third terminal 154 and fourth terminal 156 (FIG. 3C). At this point, when the opposing ends of a lightly doped polysilicon film (base body 152) are doped with impurities to form third terminal 154 and fourth terminal 156, the impurity doped in base body 152 and the impurity doped in third terminal 154 and fourth terminal 156 preferably have the same polarity. When first capacitor electrode 110 is an impurity-doped silicon substrate, the opposing ends of the polysilicon film are preferably doped with an impurity having a polarity different from the polarity of the impurity doped in the silicon substrate. Moreover, third terminal 154 and fourth terminal 156, which are made of metal, may be respectively connected to the opposing ends of the polysilicon film (base body 152) (see FIGS. 5A to FIG. 9).

Next, as illustrated in FIG. 3D, second capacitor electrode 140 is formed on first insulating film 120 at a predetermined position where second capacitor electrode 140 does not contact variable resistance element 150. For example, an impurity-doped polysilicon film or an aluminum film is formed on first insulating film 120 at a predetermined position. At this point, when first capacitor electrode 110 is an impurity-doped silicon substrate and second capacitor electrode 140 is an impurity-doped polysilicon film, the polysilicon film that results in second capacitor electrode 140 is doped with an impurity having a polarity different from the polarity of the impurity doped in the silicon substrate.

Lastly, as illustrated in FIG. 3E, second insulating film 130 is modified with recognition substance 162 at a predetermined position to form reaction section 160. For example, antibody is immobilized on second insulating film 130 at a predetermined position. It is to be noted that when reaction section 160 is directly disposed on the other side of first capacitor electrode 110, antibody is immobilized on the other side of first capacitor electrode 110.

With the procedure described above, sensor 100 illustrated in FIG. 2 can be manufactured. As will be described later, a sensor of the present invention may further include an interlayer film and the like (see FIGS. 5A, 5B, and 7 to 9).

### [Configuration of Sensor Module]

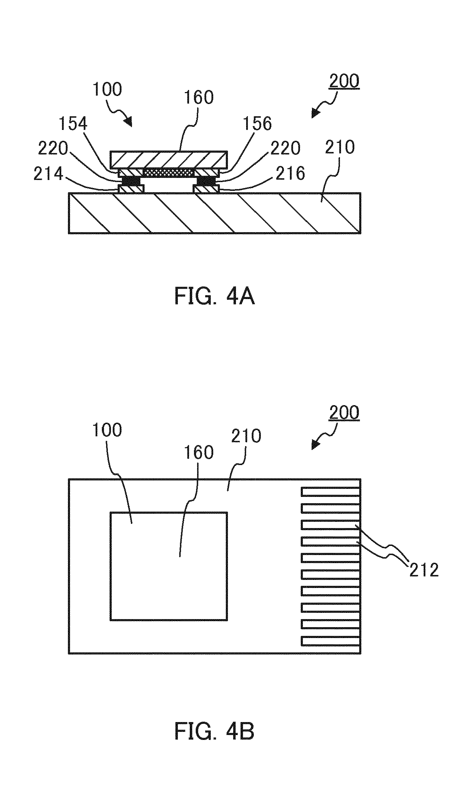

FIGS. 4A and 4B are cross-sectional schematic views illustrating an exemplary configuration of a sensor module of the present invention. FIG. 4A is a cross-sectional schematic view of the sensor module, and FIG. 4B is a plan schematic view of the sensor module. As illustrated in FIGS. 4A and 4B, sensor module 200 of present invention includes sensor 100 of the present invention and sensor module substrate 210. In FIGS. 4Aand 4B, some elements of sensor 100 are not illustrated (also in FIGS. 5A and 5B).

Sensor module substrate 210 includes connection terminals 212 for connection between sensor 100 and an external device (e.g., power source or measurement device). Connection terminals 212 are electrically connected to fifth terminal 214 and sixth terminal 216 formed on sensor module substrate 210.

Sensor 100 is fixed to sensor module substrate 210 such that variable resistance element 150 and sensor module substrate 210 of sensor 100 face each other. Accordingly, reaction section 160 is exposed to the outside (user side) at all times. Third terminal 154 and fourth terminal 156 of variable resistance element 150 are connected and fixed to fifth terminal 214 and sixth terminal 216 of sensor module substrate 210, respectively. Fixation of the terminals is effected for example by the use of conductive binder 220 such as solder or silver paste. Further, in order to ensure more reliable fixation of sensor 100 to sensor module substrate 210, an insulating adhesive may be injected between sensor 100 and sensor module substrate 210 and cured.

FIGS. 5A and 5B are cross-sectional schematic views illustrating another exemplary configuration of a sensor module of the present invention. As illustrated in FIGS. 5A and 5B, sensor module 200' may include two sensors 100a, 100b having the same specification and characteristics. One sensor 100a is used for detection and the other sensor 100b for reference. An external measurement device can utilize a difference value of output between the two sensors 100a, 100b to eliminate influences from the external environment and therefore can achieve highly precise and highly sensitive detection of a detection target substance.

### [Method of Using Sensor]

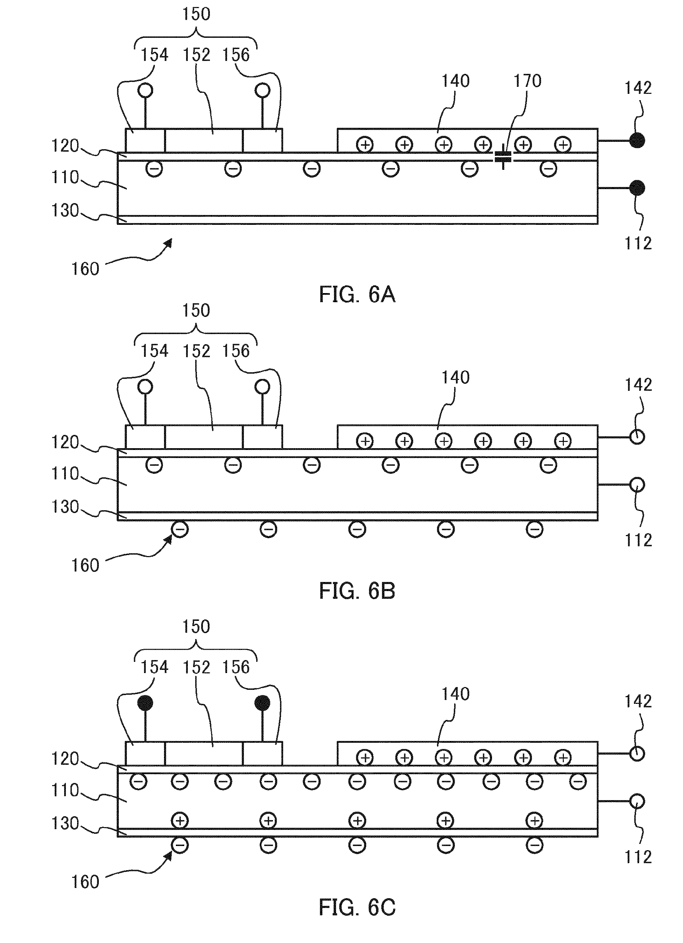

With reference to FIGS. 6A to 6C, an exemplary procedure for detecting a detection target substance by means of sensor 100 and a deduced detection mechanism will now be described. FIGS. 6A to 6C are cross-sectional schematic views of sensor 100 for explaining the operation principle of sensor 100. In these drawings recognition substance 162 is not illustrated.

First, first terminal 112 and second terminal 142 are connected to a power source (connection is indicated by a black circle in the drawings), and a predetermined level of voltage is applied between first capacitor electrode 110 and second capacitor electrode 140. At this point, application of voltage is preferably effected such that no depletion layer is formed in first capacitor electrode 110 on the first insulating film side and in second capacitor electrode 140 on the first insulating film side. As described above, first capacitor electrode 110, first insulating film 120 and second capacitor electrode 140 constitute capacitor 170. Accordingly, as illustrated in FIG. 6A, it is possible to accumulate charges, which can be controlled depending solely on the applied voltage and the capacitor value of capacitor 170, in first insulating film 120 and second capacitor electrode 140.

First terminal 112 and second terminal 142 are then disconnected from the power source (disconnection is indicated by a white circle in the drawings) so that first capacitor electrode 110 and second capacitor electrode 140 are brought into isolated state (not illustrated). This causes the charges accumulated in first capacitor electrode 110 and second capacitor electrode 140 to become isolated charges. The isolated charge greatly affects the detection sensitivity of sensor 100. Accordingly, the voltage to be applied between first capacitor electrode 110 and second capacitor electrode 140 is appropriately determined according to the required detection sensitivity.

In this state, a predetermined level of voltage is applied once between third terminal 154 and fourth terminal 156 of variable resistance element 150 (voltage application is indicated by a black circle in the drawings), and a current value between third terminal 154 and fourth terminal 156 and is measured.

Next, an analyte is fed to reaction section 160, allowing a detection target substance contained in the analyte to react with recognition molecule 162 immobilized on second insulating film 130. As illustrated in FIG. 6B, this reaction produces charges on second insulating film 130. Further, as illustrated in FIG. 6C, first capacitor electrode 110 is polarized by the electric field generated by the charges produced on second insulating film 130, so that new charges are also induced in first capacitor electrode 110. When second insulating film 130 is not provided, first capacitor electrode is polarized by the electric field generated by the charged produced by a reaction between recognition molecule 162 directly immobilized on the other side of first capacitor electrode 110 and the detection target substance contained in the analyte, so that new charges are induced in first capacitor electrode 110.

In this state, a predetermined level of voltage (same level as that for the first measurement) is again applied between third terminal 154 and fourth terminal 156 of variable resistance element 150, and a current value between third terminal 154 and fourth terminal 156 is measured. The second measurement after analyte feeding may be carried out either before or after the analyte is dried. In the first measurement before analyte feeding, the resistance value of variable resistance element 150 is determined by the electric field formed by the isolate charges accumulated in first capacitor electrode 110. On the other hand, in the second measurement after analyte feeding, the resistance value of variable resistance element 150 is determined by the electric field generated by the isolated charges accumulated in first capacitor electrode 110 and the charges in polarized first capacitor electrode 110 which have been induced by the charges generated in reaction section 160. Accordingly, detection of the presence or absence of the detection target substance or measurement of the concentration of the detection target substance is made possible based on a change in current value between before and after analyte feeding.

Looking at the relationship between electric field and resistance value of variable resistance element 150, the range within which changes in resistance value show great sensitivity to changes in electric field is generally limited. It is thus required to adjust the amount of isolated charges in first capacitor electrode 110 such that changes in resistance value of variable resistance element 150 show great sensitivity to changes in electric field caused by the reaction in reaction section 160.

With the procedure described above, detection of the presence or absence of a detection target substance or measurement of the concentration of the detection target substance is made possible using sensor 100.

It is to be noted that from the perspective of improving detection precision, it is preferable to remove residual charges in first capacitor electrode 110 and second capacitor electrode 140 immediately before application of a voltage between first capacitor electrode 110 and second capacitor electrode 140. This makes it possible to more precisely control the amount of isolated charges in first capacitor electrode 110.

### [Method of Using Sensor Module]

An exemplary procedure for detecting a detection target substance using sensor module 200' illustrated in FIGS. 5A and 5B will now be described.

First, first terminal 112 and second terminal 142 of both of detection sensor 100a and reference sensor 100b are connected to a power source, and a predetermined level of voltage is applied between first capacitor electrode 110 and second capacitor electrode 140 simultaneously for both of detection sensor 100a and reference sensor 100b. In this way charges which can be controlled depending solely on the applied voltage and the capacitor value of capacitor 170 can be accumulated in first insulating film 120 and second capacitor electrode 140 of both of sensors 100a, 100b.

Subsequently, first terminal 112 and second terminal 142 are disconnected from the power source simultaneously for both of sensors 100a, 100b, so that first capacitor electrode 110 and second capacitor electrode 140 are brought into isolated state. This causes the charges accumulated in first capacitor electrode 110 and second capacitor electrode 140 of both of sensors 100a, 100b to become isolated charges.

In this state, a predetermined level of the same voltage is applied between third terminal 154 and fourth terminal 156 of variable resistance element 150 of both of sensors 100a, 100b, and a current value between third terminal 154 and fourth terminal 156 and is measured. A difference value between the current value in detection sensor 100a and the current value in reference sensor 100b is then measured. When the difference value is not 0, offset adjustment is carried out such that the difference value becomes 0 in an external measurement device.

Subsequently, an analyte is fed to reaction section 160 of detection sensor 100a, allowing the detection target substance contained in the analyte to react with recognition molecules 162 immobilized in reaction section 160. At this point, no analyte is fed to reference sensor 100b.

In this state, a predetermined level of voltage (same voltage in the first measurement) is again applied between third terminal 154 and fourth terminal 156 of variable resistance element 150 of both of sensors 100a, 100b, and a current value between third terminal 154 and fourth terminal 156 is measured. In the first measurement before analyte feeding, the resistance value of variable resistance element 150 is determined by the electric field formed by the isolate charges accumulated in first capacitor electrode 110. On the other hand, in the second measurement after analyte feeding, the resistance value of variable resistance element 150 is determined by the electric field generated by the isolated charges accumulated in first capacitor electrode 110 and the charges in polarized first capacitor electrode 110 which have been induced by the charges generated in reaction section 160. Since the difference value between the current values of sensors 100a, 100b has been adjusted to 0 prior to analyte feeding, the difference value between the current values of sensors 100a, 100b after analyte feeding is such a value that reflects only the effect of the charges generated in reaction section 160 of detection sensor 100a. Furhter, with an external measurement device, the difference between the current values of sensors 100a, 100b may be amplified for improved sensitivity. Accordingly, measurement of a difference value between the current values of sensors 100a, 100b allows for the detection of the presence or absence of the detection target substance or for the measurement of the concentration of the detection target substance.

By measuring a difference value between the current values of sensors 100a, 100b in the manner described above, it is possible to eliminate influences of variable factors common to sensors 100a, 100b and thus to detect only the effect of the detection target substance with high sensitivity. Namely, using sensor module 200' it is possible to detect the presence or absence of the detection target substance or measure the concentration of the detection target substance with high sensitivity and high precision.

As described above, sensor 100 and sensor modules 200, 200' of the present invention do not require repetitive contact of electrodes as required in the sensors of the related art (see PTLS 1 and 2) and therefore can detect the presence or absence of a detection target substance or measure the concentration of the detection target substance with high precision and stability. Moreover, sensor 100 and sensor modules 200, 200' of the present invention can easily and stably improve detection sensitivity by adjusting the amount of isolated charges in first capacitor electrode 110.

### [Exemplary Configuration of Sensor on First Insulating Film Side]

An exemplary configuration of a sensor of the present invention on the first insulating film 120 side will now be described in detail with reference to the drawings. In the following description, description regarding the second insulating film and reaction section is not provided. It is to be noted that the second insulating film may be dispensed with in each embodiment.

### (Embodiment 1)

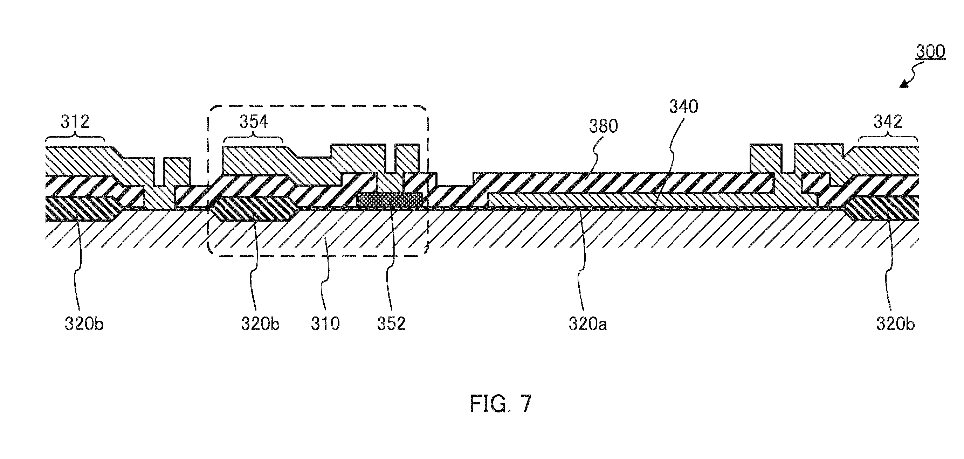

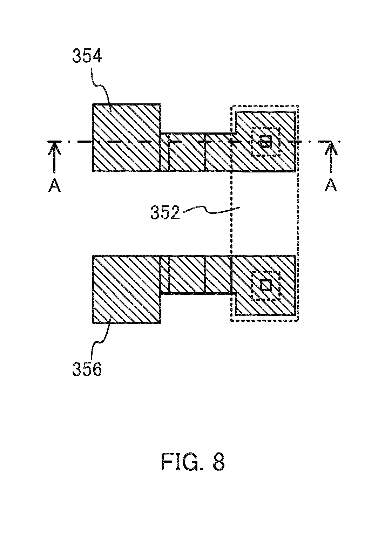

FIG. 7 is a partially enlarged cross-sectional view of sensor 300 according to Embodiment 1. In FIG. 7, part of first capacitor electrode 310, and the second insulating film and reaction section are not illustrated. FIG. 8 is a partially enlarged plan view of a part in FIG. 7 encircled by a broken line. In FIG. 8, the position of base body 352 is indicated by a broken line. The cross-sectional view of FIG. 7 illustrates a cross section of FIG. 8 cut along line A-A.

As illustrated in FIGS. 7 and 8, sensor 300 includes first capacitor electrode 310, first terminal 312, first insulating film 320, second insulating film (not illustrated), second capacitor electrode 340, second terminal 342, base body 352, third terminal 354, fourth terminal 356, reaction section (not illustrated), and interlayer film 380.

First capacitor electrode 310 is an impurity-doped silicon substrate. First insulating film 320 made of silicon oxide is formed on one side of first capacitor electrode 310, and a second insulating film made of silicon oxide (not illustrated) is formed on the other side of first capacitor electrode 310. First insulating film 320 includes thin silicon oxide film 320a formed by the thermal oxidation method, and thick silicon oxide film 320b formed by the LOCOS method. Thin silicon oxide film 320a is formed under base body 352 and second capacitor electrode 340. On the other hand, thick silicon oxide film 320b is formed under first terminal 312 and second terminal 342, and third terminal 354 and fourth terminal 356.

First terminal 312 is a terminal made of aluminum for connection between first capacitor electrode 310 and an external power source. First terminal 312 is disposed on interlayer film 380 and is electrically connected to first capacitor electrode 310 via contact holes provided in interlayer film 380.

Second capacitor electrode 340 is a polysilicon film disposed on first insulating film 320. First capacitor electrode 310, first insulating film 320 (thin silicon oxide film 320a) and second capacitor electrode 340 constitute a capacitor.

Second terminal 342 is a terminal made of aluminum for connection between second capacitor electrode 340 and an external power source. Second terminal 342 is disposed on interlayer film 380 and is electrically connected to second capacitor electrode 340 via contact holes provided in interlayer film 380.

Base body 352 is a non-doped or lightly doped polysilicon film formed on first insulating film 320 (thin silicon oxide film 320a). Base body 352, third terminal 354 and fourth terminal 356 constitute variable resistance element 150.

Interlayer film 380 is an insulating film formed on first insulating film 320, second capacitor electrode 340, and base body 352. Interlayer film 380 is for example a silicon oxide film. Interlayer film 380 protects base body 352 as well as insulates between members such that the terminals (first terminal 312, second terminal 342, third terminal 354 and fourth terminal 356) are electrically connected only to predetermined members. Other examples of materials for interlayer film 380 include silicon nitride, aluminum oxide, hafnium oxide, zirconium oxide, and titanium oxide.

Third terminal 354 is a terminal made of aluminum for connection between one end of base body 352 and an external power source. Similarly, fourth terminal 356 is a terminal made of aluminum for connection between the other end of base body 352 and an external power source. Third terminal 354 and fourth terminal 356 are disposed on interlayer film 380 and are respectively electrically connected to the one end and the other end of base body 352 via contact holes provided in interlayer film 380.

Sensor 300 according to Embodiment 1 has a large charge injection capacity per unit area compared to sensors 400, 500, 600 according to Embodiments 2 to 4 and therefore can be further downsized. Moreover, since sensor 300 according to Embodiment 1 employs a simple configuration, sensor 300 may be manufactured with fewer steps.

### (Embodiment 2)

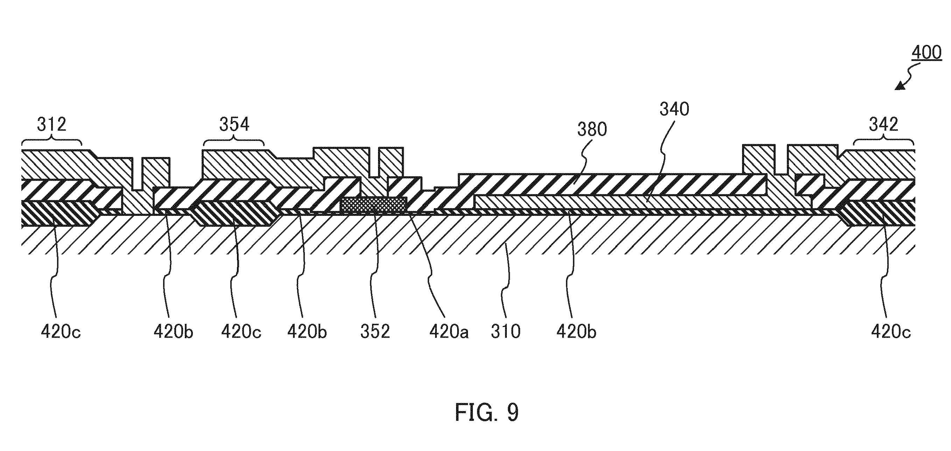

FIG. 9 is a partially enlarged cross-sectional view of sensor 400 according to Embodiment 2. In FIG. 9, part of first capacitor electrode 310, and second insulating film and reaction section are not illustrated. In the following description, components identical to those of sensor 300 according to Embodiment 1 are given reference signs identical to those for Embodiment 1, and description of such components is not provided.

As illustrated in FIG. 9, sensor 400 includes first capacitor electrode 310, first terminal 312, first insulating film 420, second insulating film (not illustrated), second capacitor electrode 340, second terminal 342, base body 352, third terminal 354, fourth terminal (not illustrated), reaction section (not illustrated), and interlayer film 380.

First insulating film 420 includes thin silicon oxide film 420a and silicon oxide film 420b which are formed by the thermal oxidation method, and thick silicon oxide film 420c formed by the LOCOS method. The thickness of silicon oxide film 420b is larger than the thickness of silicon oxide film 420a. Thin silicon oxide film 420a is formed under base body 352. Silicon oxide film 420b is formed under second capacitor electrode 340. Thick silicon oxide film 420c is formed under first terminal 312, second terminal 342, third terminal 354 and fourth terminal 356. First capacitor electrode 310, first insulating film 420 (silicon oxide film 420b formed by the thermal oxidation method) and second capacitor electrode 340 constitute a capacitor.

In sensor 400 according to Embodiment 2, first insulating film 420 that contacts second capacitor electrode 340 (silicon oxide film 420b formed by the thermal oxidation method) has a large thickness compared to that of sensor 300 according to Embodiment 1. Thus, it is possible to reduce the defect density in the first insulating film at a portion between first capacitor electrode 310 and second capacitor electrode 340. Sensor 400 according to Embodiment 2 has a large charge injection capacity per unit area compared to sensors 500, 600 according to Embodiments 3 and 4 and therefore can be further downsized. Since sensor 400 according to Embodiment 2 employs a simple configuration compared to sensors 500, 600 according to Embodiments 3 and 4, sensor 400 may be manufactured in fewer steps.

### (Embodiment 3)

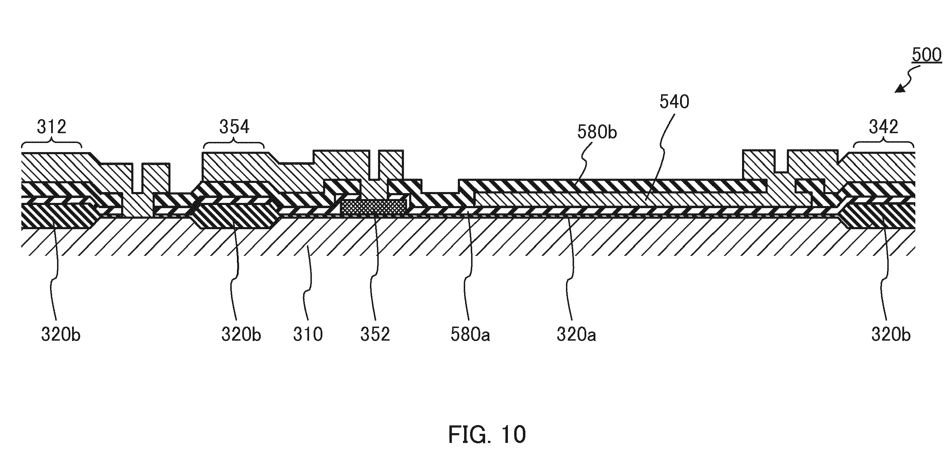

FIG. 10 is a partially enlarged cross-sectional view of sensor 500 according to Embodiment 3. In FIG. 10, part of first capacitor electrode 310, and second insulating film and reaction section are not illustrated. In the following description, components identical to those of sensor 300 according to Embodiment 1 are given reference signs identical to those for Embodiment 1, and description of such components is not provided.

As illustrated in FIG. 10, sensor 500 includes first capacitor electrode 310, first terminal 312, first insulating film 320, second insulating film (not illustrated), second capacitor electrode 540, second terminal 342, base body 352, third terminal 354, fourth terminal (not illustrated), reaction section (not illustrated), first interlayer film 580a, and second interlayer film 580b.

First interlayer film 580a is an insulating film formed on first insulating film 320 and base body 352. First interlayer film 580a is for example a silicon oxide film. First interlayer film 580a ensures, together with first insulating film 320 (thin silicon oxide film 320a), reliable insulation between first capacitor electrode 310 and second capacitor electrode 540. Other examples of materials for first interlayer film 580a include silicon nitride, aluminum oxide, hafnium oxide, zirconium oxide, and titanium oxide.

Second capacitor electrode 540 is a polysilicon film formed on first interlayer film 580a. First capacitor electrode 310, first insulating film 320 (thin silicon oxide film 320a), first interlayer film 580a and second capacitor electrode 540 constitute a capacitor.

Second interlayer film 580b is an insulating film formed on second capacitor electrode 540 and first interlayer film 580a. Second interlayer film 580b is for example a silicon oxide film. Second interlayer film 580b insulates between members such that the terminals (first terminal 312, second terminal 342, third terminal 354, and fourth terminal 356) are electrically connected only to predetermined members. Other examples of materials for second interlayer film 580b include silicon nitride, aluminum oxide, hafnium oxide, zirconium oxide, and titanium oxide.

Sensor 500 according to Embodiment 3 has a small charge injection capacity per unit area compared to sensors 300, 400 according to Embodiments 1 and, but has high capacitor reliability.

### (Embodiment 4)

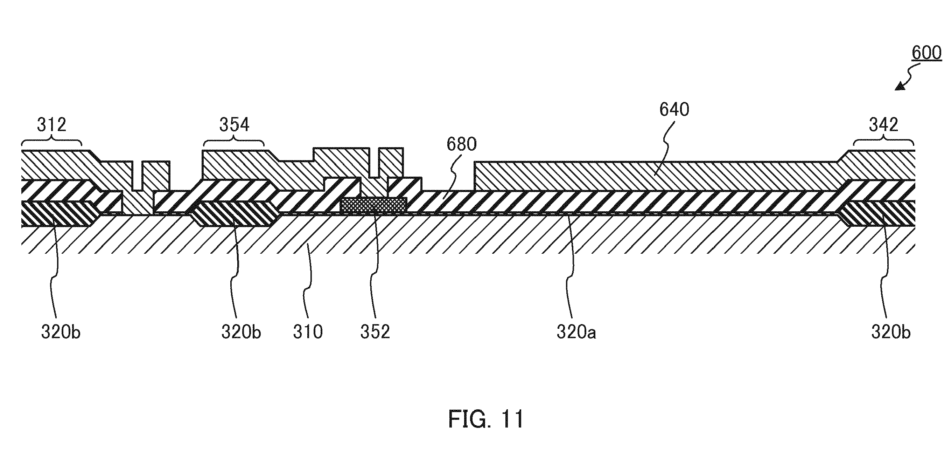

FIG. 11 is a partially enlarged cross-sectional view of sensor 600 according to Embodiment 4. In FIG. 11, part of first capacitor electrode 310, and the second insulating film and reaction section are not illustrated. In the following description, components identical to those of sensor 300 according to Embodiment 1 are given reference signs identical to those for Embodiment 1, and description of such components is not provided.

As illustrated in FIG. 11, sensor 600 includes first capacitor electrode 310, first terminal 312, first insulating film 320, second insulating film (not illustrated), second capacitor electrode 640, second terminal 342, base body 352, third terminal 354, fourth terminal (not illustrated), reaction section (not illustrated), and interlayer film 680.

Interlayer film 680 is an insulating film formed on first insulating film 320 and base body 352. Interlayer film 680 is for example a silicon oxide film. Interlayer film 680 protects base body 352 as well as insulates between members such that the terminals (first terminal 312, second terminal 342, third terminal 354, and fourth terminal 356) are electrically connected only to predetermined members. Other examples of materials for interlayer film 680 include silicon nitride, aluminum oxide, hafnium oxide, zirconium oxide, and titanium oxide.

Second capacitor electrode 640 is an aluminum film disposed on interlayer film 680. First capacitor electrode 310, first insulating film 320 (thin silicon oxide film 320a), interlayer film 680 and second capacitor electrode 640 constitute a capacitor.

Sensor 600 according to Embodiment 4 offers high capacitor reliability despite the fact that sensor 600 can be manufactured in the same number of steps as for sensor 300 according to Embodiment 1.

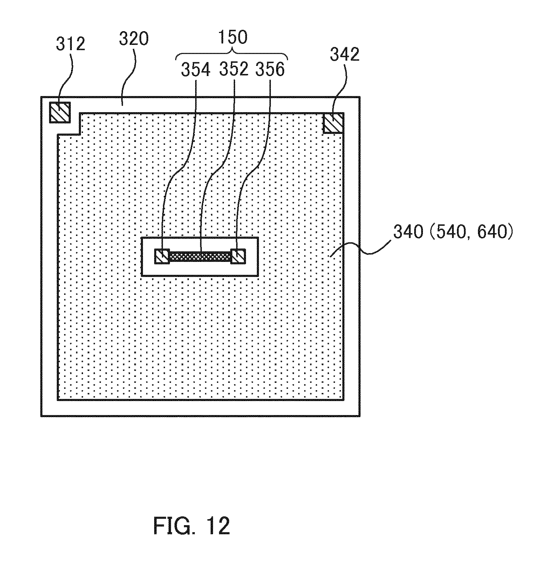

It is to be noted that although Embodiments 1 to 4 are directed to examples where second capacitor electrode 340, 540, 640 is disposed beside variable resistance element 150 (base body 352, third terminal 354 and fourth terminal 356), second capacitor electrode 340, 540, 640 may be disposed so as to surround variable resistance element 150. FIG. 12 is a plan view of sensor 300, 400, 500, 600 in which second capacitor electrode 340, 540, 640 is disposed so as to surround variable resistance element 150. In this drawing, no interlayer film is illustrated. By disposing second capacitor electrode 340, 540, 640 so as to surround variable resistance element 150 as described above, it is possible to reduce influences of rearrangement of charges that occurs when the power source is disconnected after the charge accumulation process.

### [Characteristics of Sensor]

Characteristics of the sensor of the present invention were confirmed using two different devices.

### [Device used in Confirmation Experiments 1 to 3]

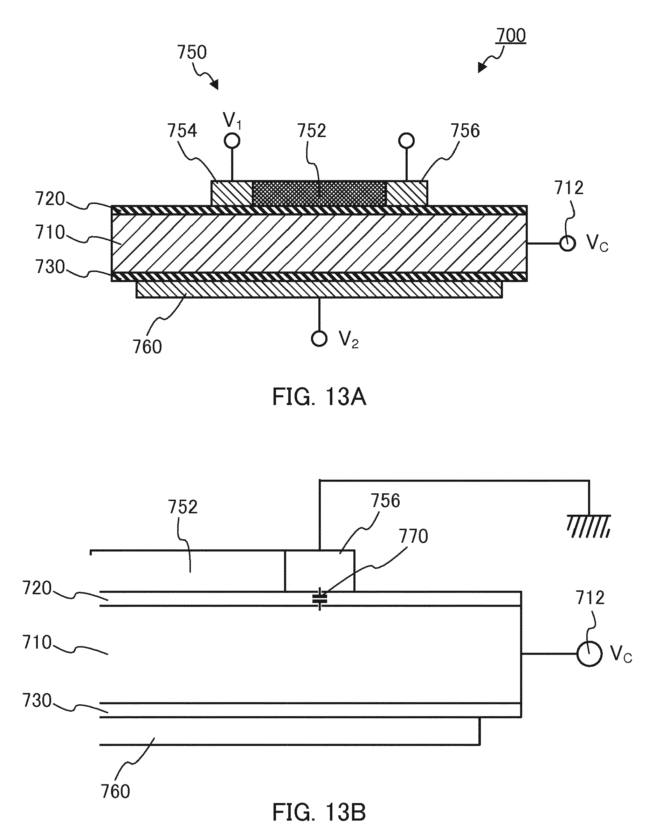

In Confirmation Experiments 1 to 3, experiments were carried out using device 700 illustrated in FIGS. 13A and 13B. In Confirmation Experiments 1 to 3, it was confirmed that even a small capacitor composed of the first capacitor electrode and of the second capacitor electrode that utilizes part of the base body of the variable resistance element was able to realize the function of the sensor of the present invention.

As illustrated in FIG. 13A, device 700 includes p-type impurity-doped silicon substrate (first capacitor electrode) 710, silicon oxide film (first insulating film) 720 formed on one side of silicon substrate 710, silicon oxide film (second insulating film) 730 formed on the other side of silicon substrate 710, variable resistance element 750 formed on silicon oxide film 720, and backside electrode 760 formed on silicon oxide film 730. Variable resistance element 750 was fabricated by doping opposing ends of 30 µm-width non-doped polysilicon film (base body) 752 with n-type impurities to form third terminal 754 and fourth terminal 756. On the lateral side surface of silicon substrate 710, first terminal 712 is formed for connection to a power source for applying charge injection voltage (V_{c}) between silicon substrate 710, and third terminal 754 and fourth terminal 756.

In device 700, no second capacitor electrode was formed; instead, third terminal 754 and fourth terminal 756 were allowed to function as the second capacitor electrode. Accordingly, as illustrated in FIG. 13B, when charge injection voltage (V_{c}) is applied between silicon substrate 710, and third terminal 754 and fourth terminal 756, capacitor 770 is formed between silicon substrate 710, and third terminal 754 and fourth terminal 756.

Because Confirmation Experiments 1 to 3 are aimed at measuring electrical characteristics of device 700, instead of reaction section, backside electrode 760 for applying desired voltage V₂ was provided without forming any reaction section. Backside electrode 760 was fabricated by applying silver paste on silicon oxide film 730 and drying the silver paste.

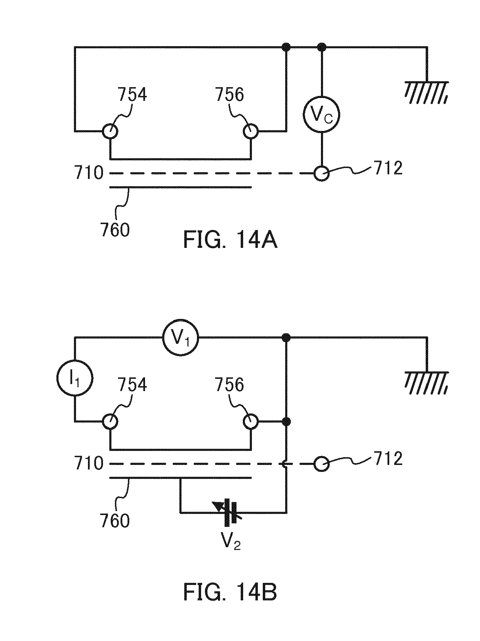

FIGS. 14A and 14B illustrate two different experimental circuits used in Confirmation Experiments 1 to 3. The circuit illustrated in FIG. 14A is for accumulating charges in capacitor 770 formed between silicon substrate 710, and third terminal 754 and fourth terminal 756. The circuit illustrated in FIG. 14B is for measuring current I₁ between third terminal 754 and forth terminal 756 after charge accumulation in silicon substrate 710. In the circuit illustrated in FIG. 14B, silicon substrate 710 is in isolated state where it is disconnected from the power source.

### (Confirmation Experiment 1)

In Confirmation Experiment 1, the relationship between applied charge injection voltage (V_{c}) and current (I₁) between third terminal 754 and fourth terminal 756 was confirmed.

In the circuit illustrated in FIG. 14A, voltage V_{c} was applied to capacitor 770 formed between silicon substrate 710, and third terminal 754 and fourth terminal 756, so that an amount of charges that matches the applied voltage V_{c} is accumulated in silicon substrate 710. Next, in the circuit illustrated in FIG. 14B, current (I₁) between third terminal 754 and fourth terminal 756 was measured with 1V of voltage (V₁) being applied between third terminal 754 and fourth terminal 756. A measurement in accordance with this procedure was repeated while changing applied voltage V_{c} from 0V to 10V in increments of 1V

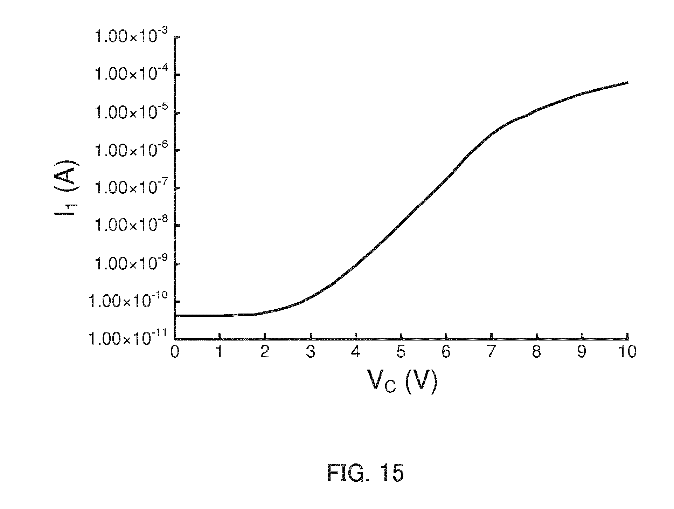

FIG. 15 is a graph of measurement results. This graph confirms that appropriate selection of voltage V_{c} to be applied for accumulating charges in silicon substrate 710 may improve the sensitivity of detecting changes in current (I₁) that flows through variable resistance element 750.

### (Confirmation Experiment 2)

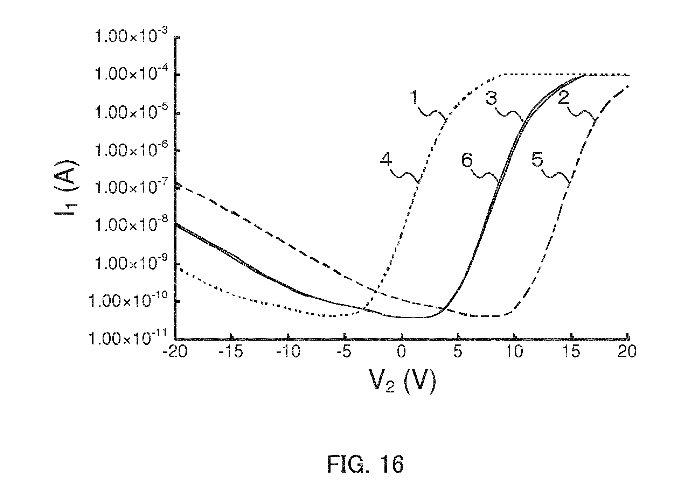

In Confirmation Experiment 2, the relationship between voltage V₂ applied to backside electrode 760 and current (I₁) between third terminal 754 and fourth terminal 756 was repeatedly measured while changing voltage V_{c} applied for charge accumulation, to confirm the reproducibility of the measurement value. FIG. 16 is a graph of measurement results.

In the circuit illustrated in FIG. 14A, +5V of voltage V_{c} was applied to capacitor 770 formed between silicon substrate 710, and third terminal 754 and fourth terminal 756 to accumulate a predetermined amount of charges in silicon substrate 710. Next, in the circuit illustrated in FIG. 14B, voltage V₂ to be applied to backside electrode 760 was swept in the range from -20V to +20V with 1V of voltage (V₁) being applied between third terminal 754 and fourth terminal 756, and current (I₁) between third terminal 754 and fourth terminal 756 was measured. The measurement result is indicated in FIG. 16 by a curve with number 1.

Next, in the circuit illustrated in FIG. 14A, -5V of voltage V_{c} was applied to capacitor 770 formed between silicon substrate 710, and third terminal 754 and fourth terminal 756 to accumulate a predetermined amount of charges in silicon substrate 710. Subsequently, in the circuit illustrated in FIG. 14B, voltage V₂ to be applied to backside electrode 760 was swept in the range from -20V to +20V with 1V of voltage (V₁) being applied between third terminal 754 and fourth terminal 756, and current (I₁) between third terminal 754 and fourth terminal 756 was measured. The measurement result is indicated in FIG. 16 by a curve with number 2.

Next, in the circuit illustrated in FIG. 14A, 0V of voltage V_{c} was applied to capacitor 770 formed between silicon substrate 710, and third terminal 754 and fourth terminal 756 to accumulate a predetermined amount charges in silicon substrate 710. Subsequently, in the circuit illustrated in FIG. 14B, voltage V₂ to be applied to backside electrode 760 was swept in the range from -20V to +20V with 1V of voltage (V₁) being applied between third terminal 754 and fourth terminal 756, and current (I₁) between third terminal 754 and fourth terminal 756 was measured. The measurement result is indicated in FIG. 16 by a curve with number 3.

Next, in the circuit illustrated in FIG. 14A, +5V of voltage V_{c} was applied to capacitor 770 formed between silicon substrate 710, and third terminal 754 and fourth terminal 756 to accumulate a predetermined amount of charges in silicon substrate 710. Subsequently, in the circuit illustrated in FIG. 14B, voltage V₂ to be applied to backside electrode 760 was swept in the range from -20V to +20V with 1V of voltage (V₁) being applied between third terminal 754 and fourth terminal 756, and current (I₁) between third terminal 754 and fourth terminal 756 was measured. The measurement result is indicated in FIG. 16 by a curve with number 4.

Next, in the circuit illustrated in FIG. 14A, -5V of voltage V_{c} was applied to capacitor 770 formed between silicon substrate 710, and third terminal 754 and fourth terminal 756 to accumulate a predetermined amount of charges in silicon substrate 710. Subsequently, in the circuit illustrated in FIG. 14B, voltage V₂ to be applied to backside electrode 760 was swept in the range from -20V to +20V with 1V of voltage (V₁) being applied between third terminal 754 and fourth terminal 756, and current (I₁) between third terminal 754 and fourth terminal 756 was measured. The measurement result is indicated in FIG. 16 by a curve with number 5.

Next, in the circuit illustrated in FIG. 14A, 0V of voltage V_{c} was applied to capacitor 770 formed between silicon substrate 710, and third terminal 754 and fourth terminal 756 to accumulate a predetermined amount charges in silicon substrate 710. Subsequently, in the circuit illustrated in FIG. 14B, voltage V₂ to be applied to backside electrode 760 was swept in the range from -20V to +20V with 1V of voltage (V₁) being applied between third terminal 754 and fourth terminal 756, and current (I₁) between third terminal 754 and fourth terminal 756 was measured. The measurement result is indicated in FIG. 16 by a curve with number 6.

The graph of FIG. 16 confirms that hysteresis depending on applied voltage V_{c} did not occur, i.e., V₂-I₁ characteristics were determined solely by applied voltage V_{c} and also good reproducibility was attained.

### (Confirmation Experiment 3)

In Confirmation Experiment, it was confirmed whether or not current (I₁) between third terminal 754 and fourth terminal 756 changes with time.

In the circuit illustrated in FIG. 14A, +7V of voltage V_{c} was applied for 60 seconds to capacitor 770 formed between silicon substrate 710, and third terminal 754 and fourth terminal 756 to accumulate a predetermined amount of charges in silicon substrate 710. Subsequently, in the circuit illustrated in FIG. 14B, a temporal change in current (I₁) between third terminal 754 and fourth terminal 756 was measured with 1V of voltage (V₁) being applied between third terminal 754 and fourth terminal 756. It is to be noted in this measurement that back electrode 760 and the power source for applying voltage V₂ were separated.

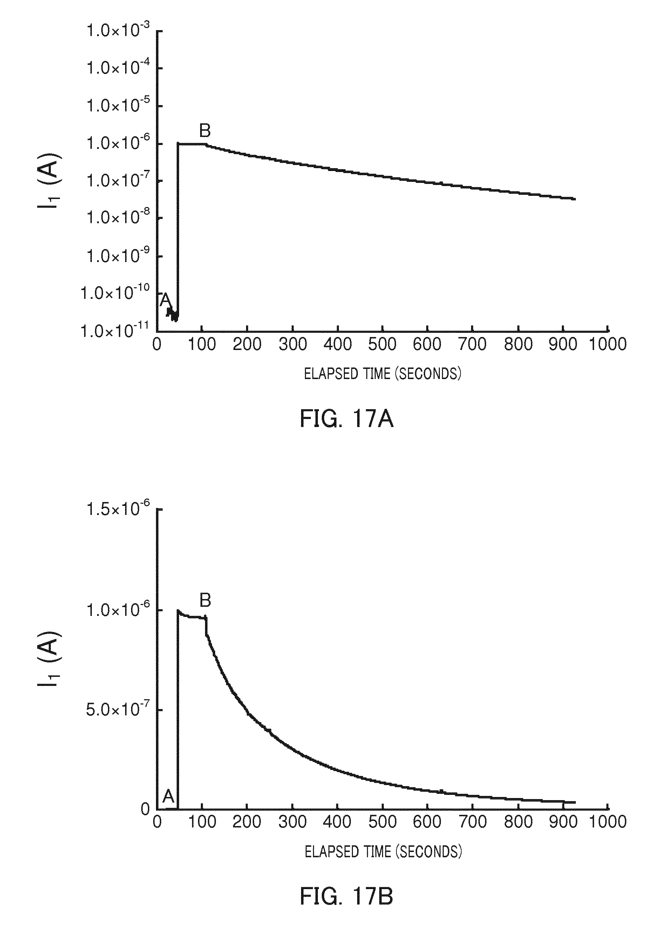

FIGS. 17A and 17B are graphs of measurement results. The numeral range of the vertical axis differs between FIGS. 17A and FIG. 17B. In FIGS. 17A and 17B, "A" denotes the timing of application of voltage V_{c}, and "B" denotes the timing when silicon substrate 710 is brought into isolated state. These graphs confirm that current (I₁) flowing through variable resistance element 750, which is determined by charges accumulated in silicon substrate 710, decreases with time. The reason for this would be that the charges accumulated in silicon substrate 710 leaked with time. A smaller capacitor value of capacitor 770 in which charges are accumulated would be responsible for vulnerability to leakage of accumulated charges via stray capacitance present in the measurement environment.

### (Devices used in Confirmation Experiments 4 to 6)

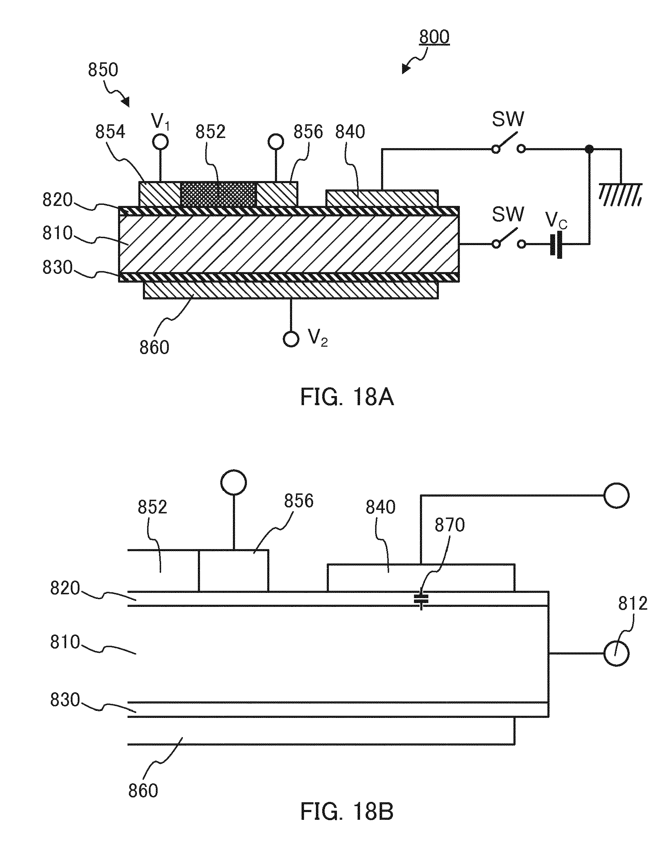

In Confirmation Experiments 4 to 6, measurements were carried out using device 800 illustrated in FIGS. 18A and 18B. In Confirmation Experiments 4 to 6, using device 800 having a capacitor-dedicated second capacitor electrode capable of forming an arbitrarily large capacitor compared to capacitor 700 in device 700 illustrated in FIG. 13A, the effect brought about by providing a capacitor-dedicated second capacitor electrode was confirmed.

As illustrated in FIG. 18A, device 800 includes n-type impurity-doped silicon substrate (first capacitor electrode) 810, silicon oxide film (first insulating film) 820 formed on one side of silicon substrate 810, silicon oxide film (second insulating film) 830 formed on the other side of silicon substrate 810, aluminum film (second capacitor electrode) 840 formed on silicon oxide film 820, variable resistance device 850 formed on silicon oxide film 820, and backside electrode 860 formed on silicon oxide film 830. Variable resistance element 850 was fabricated by doping the opposing ends of a 2,600 µm-width non-doped polysilicon film (base body) 852 with p-type impurities to form third terminal 854 and fourth terminal 856. On the lateral side surface of silicon substrate 810, first terminal 812 is formed for connection to a power source for applying charge injection voltage (V_{c}) between silicon substrate 810 and aluminum film 840. The area of aluminum film (second capacitor electrode) 840 is such a level that a capacitor can be formed which is arbitrarily large compared to capacitor 770 in device 700 illustrated in FIG. 13A. Aluminum film 840 also functions as a second terminal.

Because Confirmation Experiments 4 to 6 are aimed at measuring electrical characteristics of device 800, instead of reaction section, backside electrode 860 for applying desired voltage V₂ was provided without forming any reaction section. Backside electrode 860 was fabricated by applying silver paste on silicon oxide film 830 and drying the silver paste.

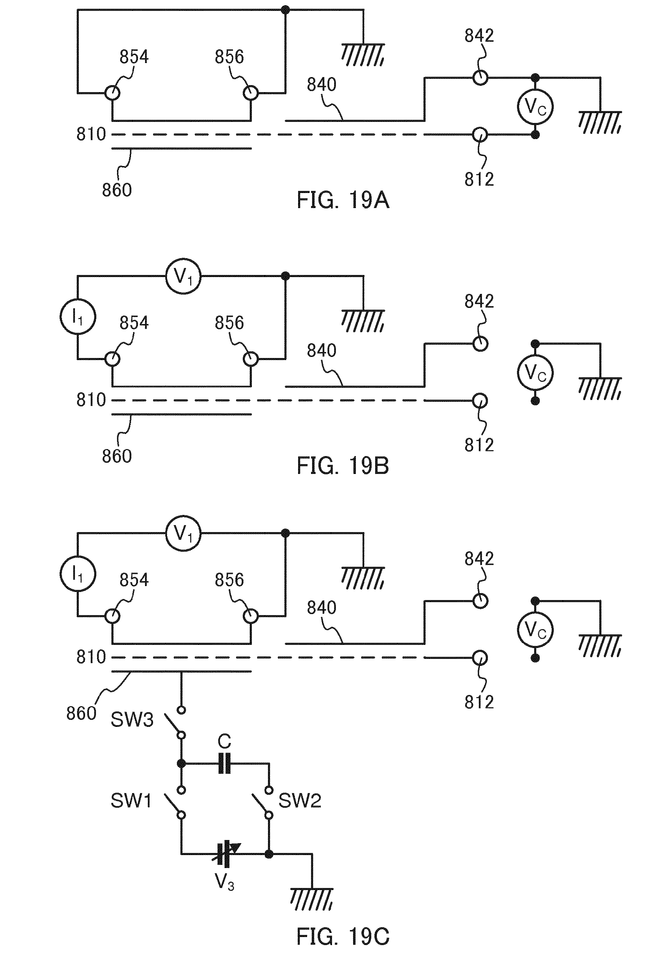

FIGS. 19A to 19C illustrate three different experimental circuits used in Confirmation Experiments 4 to 6. The circuit illustrated in FIG. 19A is for accumulating charges in capacitor 870 formed between silicon substrate 810 and aluminum film 840. The circuit illustrated in FIG. 19B is for measuring current I₁ between third terminal 854 and fourth terminal 856 after charge accumulation in silicon substrate 810. In the circuit illustrated in FIG. 19B, silicon substrate 810 is in isolated state where it is disconnected from the power source. The circuit illustrated in FIG. 18C is for measuring, after charge accumulation in silicon substrate 810, current I₁ between third terminal 854 and fourth terminal 856 with backside electrode 860 being connected to an external capacitor. In the circuit illustrated in FIG. 19C, isolated charges produced by a reaction between the recognition substance and detection target substance in the reaction section are simulated by connecting backside electrode 860 to the external capacitor.

### (Confirmation Experiment 4)

In Confirmation Experiment 4, the relationship between applied charge injection voltage (V_{c}) and current (I₁) between third terminal 854 and fourth terminal 856 was confirmed.

In the circuit illustrated in FIG. 19A, voltage V_{c} was applied to capacitor 870 formed between silicon substrate 810 and aluminum film 840, so that an amount of charges that matches the applied voltage V_{c} was accumulated in silicon substrate 810. Next, in the circuit illustrated in FIG. 19B, current (I₁) between third terminal 854 and fourth terminal 856 was measured with 1V of voltage (V₁) being applied between third terminal 854 and fourth terminal 856. A measurement in accordance with this procedure was repeated while changing applied voltage V_{c} from 0V to -4V in decrements of 0.1V.

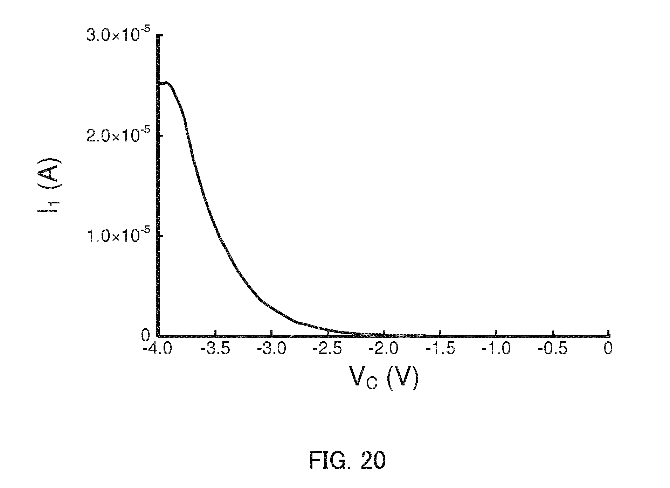

FIG. 20 is a graph of measurement results. This graph confirms that, as with device 700, appropriate selection of voltage V_{c} to be applied for accumulating charges in silicon substrate 810 may improve the sensitivity of detecting changes in current (I₁) that flows through variable resistance element 850. It is to be noted that the orientation of the characteristics curve was different between devices 700 and 800 because the polarity of the impurity doped in silicon substrate 810, the polarity of the impurity doped in third terminal 854 and fourth terminal 856, and the polarity of the applied voltage were opposite to those for device 700.

### (Confirmation Experiment 5)

In Confirmation Experiment 5, it was confirmed whether or not current (I₁) between third terminal 854 and fourth terminal 856 changes with time.

In the circuit illustrated in FIG. 19A, -3V of voltage V_{c} was applied for 15 seconds to capacitor 870 formed between silicon substrate 810 and aluminum film 840 to accumulate a predetermined amount of charges in silicon substrate 810. Subsequently, in the circuit illustrated in FIG. 19B, a temporal change in current (I₁) between third terminal 854 and fourth terminal 856 was measured with 1V of voltage (V₁) being applied between third terminal 854 and fourth terminal 856.

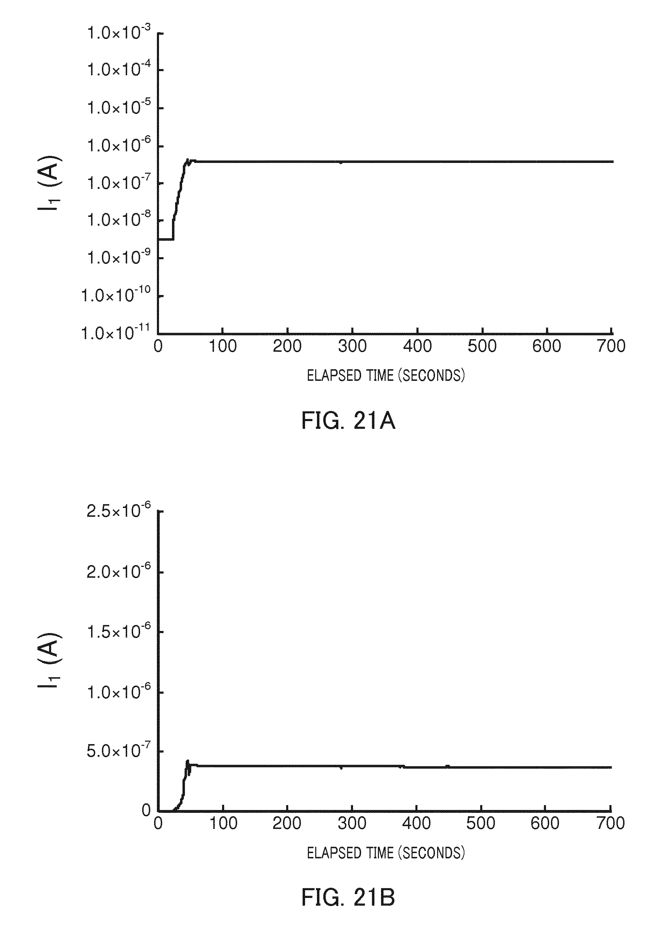

FIGS. 21A and 21B are graphs of measurement results. The numeral range of the vertical axis differs between FIGS. 21A and FIG. 21B. These graphs confirm that current (I₁) flowing through variable resistance element 850, which is determined by charges accumulated in silicon substrate 810, shows little change even when time elapses. The reason for this would be due to the effect of capacitor 870 formed between silicon substrate 810 and aluminum film 840. These results confirm that formation of capacitor 870 between silicon substrate 810 and aluminum film 840 eliminates influences of leakage of isolated charges in device 800.

### (Confirmation Experiment 6)

In Confirmation Experiment 6, in order to confirm whether or not the sensor of the present invention can detect charges produced in the reaction section, it was confirmed whether or not device 800 can detect charges produced on the backside.

First, in the circuit illustrated in FIG. 19A, -3V of voltage V_{c} was applied for 15 seconds to capacitor 870 formed between silicon substrate 810 and aluminum film 840 to accumulate a predetermined amount of charges in silicon substrate 810. Subsequently, in the circuit illustrated in FIG. 19C, current (I₁) between third terminal 854 and fourth terminal 856 was measured with SW3 being disconnected (Measurement No. 1). Afterward, current (I₁) between third terminal 854 and fourth terminal 856 was continuously measured. The applied voltage V₁ between third terminal 854 and fourth terminal 856 was set to 1V

Next, in the circuit illustrated in FIG. 19C, SW1 and SW2 were connected, SW3 was disconnected, and -1V of voltage V₃ was applied to external capacitor C to accumulate therein negative charges. Thereafter, SW1 and SW2 were disconnected and SW3 was connected so that the charges accumulated in external capacitor C were transferred to backside electrode 860, after which current (I₁) between third terminal 854 and fourth terminal 856 was measured with SW3 being disconnected (Measurement No. 2).

Next, SW1 and SW2 were connected, SW3 was disconnected, and -2V of voltage V₃ was applied to external capacitor C to accumulate therein negative charges. Thereafter, SW1 and SW2 were disconnected and SW3 was connected so that the charges accumulated in external capacitor C were transferred to backside electrode 860, after which current (I₁) between third terminal 854 and fourth terminal 856 was measured with SW3 being disconnected (Measurement No. 3). Switching of voltage to be applied to external capacitor C was carried out every 40 seconds.

In the same manner as described above, -3V of voltage V₃ and -4V of voltage V₃ were sequentially applied to the external capacitor, and current (I₁) between third terminal 854 and fourth terminal 856 was measured for each voltage application with SW3 being disconnected (Measurement Nos. 4 and 5).

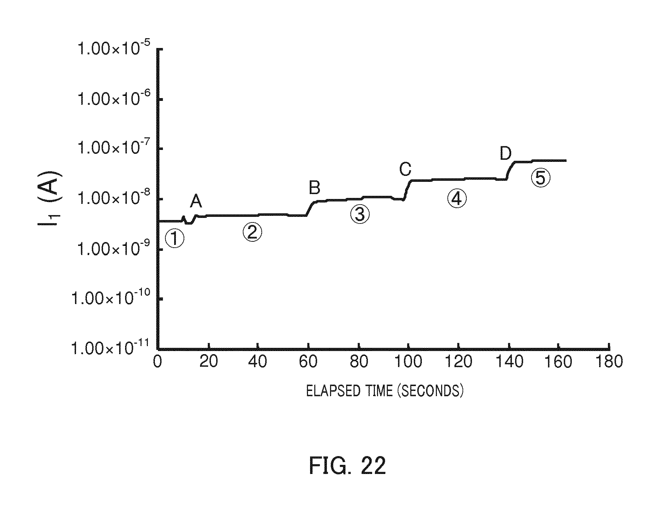

FIG. 22 is a graph of measurement results. In FIG. 22, "A" denotes the timing of application of -1V of V₃, "B" the timing of application of -2V of V₃, "C" the timing of application of -3V of V₃, and "D" the timing of application of -4V of V₃. Encircled numbers in FIG. 22 denote measurement numbers. This graph confirms that current I₁ flowing through variable resistance element 850 changes according to applied voltage V₃ for accumulating charges in external capacitor C. This means that device 800 can detect charges produced on the backside.

These results confirm that in the sensor of the present invention, it is possible to detect charges produced in the reaction section on the backside.

This application claims the priority of Japanese Patent Application No. 2012-230740 filed on October 18, 2012, the contents of which including the specification and drawings are hereby incorporated by reference in their entirety.

### Industrial Applicability

The sensor according to the present invention is suitable for the detection of infections, confirmation of food safety, detection of environmental contaminants, and so forth.

### Reference Signs List

10 sensor
11 silicon substrate
12 first insulating film
13 second insulating film
14 channel
15 source electrode
16 drain electrode
17 reaction section
18 gate electrode
19 recognition substance
20 experimental device
100, 100a, 100b, 300, 400,500, 600 sensor
110,310 first capacitor electrode
112,312,712,812 first terminal
120, 320, 420 first insulating film
130 second insulating film
140, 340, 540, 640, 840 second capacitor electrode
142, 342, 842 second terminal
150 variable resistance element
152,352 base body
154, 354, 754, 854 third terminal
156, 356, 756, 856 fourth terminal
160 reaction section
162 recognition substance
170 capacitor
200, 200' sensor module
210 sensor module substrate
212 connection terminal
214 fifth terminal
216 sixth terminal
220 conductive binder
380, 680 interlayer film
580a first interlayer film
580b second interlayer film
700, 800 device
710, 810 silicon substrate
720, 730, 820, 830 silicon oxide film
750, 850 variable resistance element
752, 852 non-doped polysilicon film
760, 860 backside electrode
770, 870 capacitor formed between silicon substrate and second terminal
840 aluminum film

## Claims

1. A sensor comprising:
a first capacitor electrode made of a plate-shaped conductor or semiconductor;
a first terminal electrically connected to the first capacitor electrode and may be electrically connected to an outside;
a first insulating film disposed on one side of the first capacitor electrode;
a second capacitor electrode made of conductor or semiconductor, the second capacitor electrode being disposed to face a part of the first capacitor electrode across the first insulating film;
a second terminal electrically connected to the second capacitor electrode and may be electrically connected to an outside;
a variable resistance element including a base body disposed on the first insulating film, a third terminal electrically connected to one end of the base body, and a fourth terminal electrically connected to the other end of the base body; and
a reaction section disposed on the other side of the first capacitor electrode either directly or with a second insulating film provided between the first capacitor electrode and the reaction section.

2. The sensor according to claim 1, wherein the first capacitor electrode is an impurity-doped silicon substrate.

3. The sensor according to claim 1, wherein the base body is a carbon nanotube or a polysilicon film.

4. The sensor according to claim 3, wherein the base body is a non-doped polysilicon film.

5. The sensor according to claim 3 or 4, wherein the first capacitor electrode is an impurity-doped silicon substrate, the base body is a polysilicon film, and the third terminal and the fourth terminals are impurity-doped polysilicon films.

6. The sensor according to claim 5, wherein an impurity doped in the first capacitor electrode and an impurity doped in the third terminal and the fourth terminal have different polarities.

7. The sensor according to claim 1, wherein the second capacitor electrode is an film made of polysilicon, metal or alloy.

8. The sensor according to claim 7, wherein the first capacitor electrode is an impurity-doped silicon substrate, the second capacitor electrode is an impurity-doped polysilicon film, and an impurity doped in the first capacitor electrode and an impurity doped in the second capacitor electrode have different polarities.

9. The sensor according to claim 1, wherein in the reaction section, a recognition substance which may react with a detection target substance is immobilized on the other side of the first capacitor electrode or on a surface of the second insulating film.

10. A sensor module comprising:
the sensor according to any one of claims 1 to 9; and
a sensor module substrate for connecting the sensor to an external device,
wherein the sensor is fixed to the sensor module substrate such that the variable resistance element faces the sensor module substrate.

11. The sensor module according to claim 10, wherein the sensor module substrate includes two of the sensors fixed thereto.

12. A method of detecting a detection target substance in an analyte using the sensor according to any one of claims 1 to 9 or the sensor module according to claim 10, the method comprising:
a first step of connecting the first terminal and the second terminal to a power source and applying a voltage between the first capacitor electrode and the second capacitor electrode;
a second step of electrically disconnecting, after the first step, the first capacitor electrode and the second capacitor electrode from the power source by electrically disconnecting the first terminal and the second terminal from the power source;
a third step of feeding, after the second step, an analyte to the reaction section; and
a fourth step of measuring, after the third step, a current value between the third terminal and the fourth terminal.

13. A method of detecting a detection target substance in an analyte using the sensor module according to claim 11, the method comprising:
a first step of electrically connecting the first terminal and the second terminal of both of the two sensors to a power source and applying a voltage between the first capacitor electrode and the second capacitor electrode simultaneously for both of the two sensors;
a second step of electrically disconnecting, after the first step, the first capacitor electrode and the second capacitor electrode of both of the two sensors from the power source by electrically disconnecting the first terminal and the second terminal from the power source simultaneously for both of the two sensors;
a third step of feeding, after the second step, an analyte to the reaction section of one of the two sensors; and
a fourth step of measuring, after the third step, a difference value between 1) a current value between the third terminal and the fourth terminal for the one of the two sensors, and 2) a current value between the third terminal and the fourth terminal for the other one of the two sensors.

14. The method according to claim 12 or 13, further comprising, before the first step, removing residual charges in the first capacitor electrode and the second capacitor electrode.
